## Europäisches Patentamt
## European Patent Office
## Office européen des brevets

(19)

(11) Numéro de publication: **0 146 418
B1**

(12) # FASCICULE DE BREVET EUROPEEN

(45) Date de publication du fascicule du brevet:
**07.01.88**

(51) Int. Cl.⁴: **G 06 F 13/00,** G 11 C 19/00,
H 03 K 23/66

(21) Numéro de dépôt: **84401952.1**

(22) Date de dépôt: **28.09.84**

(54) **File d'attente asynchrone à empilement de registres.**

(30) Priorité: **29.09.83 FR 8315510**

(43) Date de publication de la demande:
**26.06.85 Bulletin 85/26**

(45) Mention de la délivrance du brevet:
**07.01.88 Bulletin 88/1**

(84) Etats contractants désignés:
**BE CH DE GB IT LI NL SE**

(56) Documents cités:
**GB - A - 2 009 984
US - A - 3 378 776
US - A - 3 953 838**

(73) Titulaire: **Thomas, Alain, Ar Santé L 222, F-22300 Lannion
(FR)**
Titulaire: **Servel, Michel, Le Rhu en Servel,
F-22300 Lannion (FR)**

(72) Inventeur: **Thomas, Alain, Ar Santé L 222,
F-22300 Lannion (FR)**
Inventeur: **Servel, Michel, Le Rhu en Servel,
F-22300 Lannion (FR)**

(74) Mandataire: **Fort, Jacques et al, CABINET
PLASSERAUD 84, rue d'Amsterdam, F-75009 Paris (FR)**

ACTORUM AG

**Description**

L'invention concerne les files d'attente du type «premier entré premier sorti» largement utilisé en informatique et traitement numérique du signal notamment pour constituer une mémoire tampon. Elle concerne plus particulièrement les files d'attente asynchrones, c'est-à-dire n'imposant pas une relation temporelle déterminée entre l'entrée et la sortie, du type comprenant un empilement en cascade de p registres identiques de stockage de données, et une chaîne logique de commande de p sous-ensembles identiques associés chacun à un des registres, le premier registre de l'empilement étant muni de l'entrée unique de données de ladite file.

Dans une exemple représentatif, la file d'attente comporte un empilement de p registres comportant tous le même nombre de positions binaires, et la chaîne logique de commande est formée par un mécanisme à p positions binaires associées chacune à un registre de stockage.

La file est agencée pour qu'une information chargée dans le premier registre progresse spontanément de registre en registre jusqu'à se stabiliser dans le dernier registre non vide. Chaque lecture vide le dernier registre de l'empilement et la totalité de l'information stockée descend d'un degré dans la file.

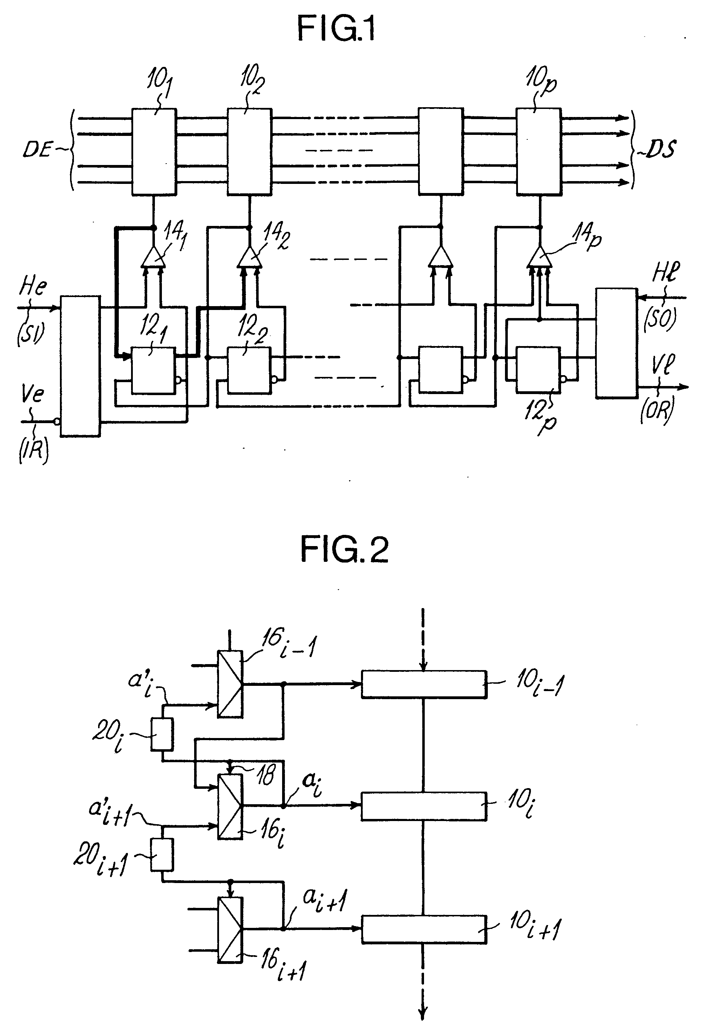

Un montage classique de réalisation d'une telle file est illustré en fig. 1. Chacun des registres $10_1 \ldots 10p$ est associé à un sous-ensemble comportant une bascule $12_1 \ldots 12p$ du type RS, toutes les bascules étant en cascade. Chaque sous-ensemble fournit un signal logique agissant sur le registre associé et indicatif de l'état libre ou occupé du registre. Ce signal logique est produit en fonction des signaux logiques de sortie du sous-ensemble précédent (ou amont), du sous-ensemble suivant (ou aval), et du sous-ensemble lui-même, les deux sous-ensembles d'extrémité exigeant naturellement un montage légèrement différent.

On voit sur la fig. 1 que le montage est tel que, lorsque le sous-ensemble d'ordre i contient un 1 tandis que le sous-ensemble d'ordre i+1 contient un 0, le sous-ensemble d'ordre i+1 délivre, par l'intermédiaire d'une porte ET 14, un signal de commande de chargement du registre de rang i+1, ce signal étant utilisé pour, d'une part, porter à 1 le sous-ensemble d'ordre i+1 et pour d'autre part, ramener à 0 le sous-ensemble d'ordre i.

Il apparaît ainsi que le signal logique de sortie d'un sous-ensemble tel que $12_1$ n'agit sur le sous-ensemble suivant, par exemple $12_2$ qu'après passage à travers le sous-ensemble lui-même, comme le font apparaître les liaisons en traits renforcés sur la fig. 1 où les diverses entrées et sorties portent les abréviations usuelles.

He: demande d'écriture
H1: demande de lecture
DE: entrée de données
DS: sortie de données

Ve: validation d'entrée
V1: validation de lecture

Un tel mécanisme a pour conséquence un temps de réaction important.

Pour plus de commodité, la fig. 1 porte également, entre parenthèse, les abréviations habituellement utilisées sur les composants d'origine anglo-saxonne.

Dans une file d'attente montré en fig. 1, la progression de l'information dans les registres de données s'effectue au rhythme des verouillages et déverrouillages des bascules RS, ce qui conduit, en cas de file presque vide, à une durée de descente importante (intervalle de temps entre l'entrée d'un mot de données dans le premier registre et disponibilité du mot en sortie).

En effet, les registres $10_1$ à 10p lisent l'information en réponse aux signaux logiques successifs émis par les sous-ensembles correspondants.

On connaît également (GB-A-2009984) une mémoire tampon organisée en file d'attente destinée à supprimer les retards de propagation à travers des registres vides. Pour cela, les données sont transmises depuis un bus directement au dernier registre vide de la file. Cette solution a l'inconvénient d'une grande complexité.

L'invention vise à fournir une file d'attente du type ci-dessus défini, mais à fonctionnement rapide et presque indépendant du degré de remplissage de la file, restant toutefois d'une réalisation simple.

Dans ce but, l'invention propose notamment une file d'attente dans laquelle les registres sont du type à verrouillage à un état transparent et un état verrouillé et chaque sous-ensemble comporte un commutateur recevant, sur ses entrées de signal, des signaux logiques représentatifs de l'état des sous-ensembles amont et aval et transmettant, sur sa sortie reliée au registre associé, l'un des deux signaux logiques d'entrée, ladite sortie fournissant un signal représentatif de l'état dudit sous-ensemble, la position du commutateur étant dommandée par le niveau logique du signal de sortie dudit commutateur.

Les registres mis en œuvre par l'invention peuvent être du type connu, par exemple peuvent être constitués par des registres F100–150 de la société Fairchild. Dans un tel registre, les données appliquées à l'entrée apparaissent instantanément sur la sortie lorsqu'une entrée de commande est à un premier niveau logique. Lorsque cette entrée de commande passe à un second niveau logique, les données appliquées à l'entrée du registre immédiatement avant la transition restent appliquées sur la sortie.

Grâce à l'emploi de tels registres, la chaîne de registres n'apporte aucun ralentissement au transit des donnés le long de la cascade lorsque les registres sont dans l'état transparent.

On pourrait penser qu'il était donc évident de substituer, aux registres classiques utilisés pour constituer des files dans l'art antérieur, des registres présentant un état transparent. Mais, en apparence, cette substitution n'apporte aucun avantage, car il faut que l'élément de commande des registres de contrôle qui accompagne l'information au cours de la descente dans la cascade progresse également jusqu'à valider l'accès aux données en sortie. Or, la progression par «demande-acquittement» des bascules RS utilisées dans les sous-ensembles de l'art antérieur est lente par nature, de sorte que la substitution d'un type de registres à un autre ne procure en soi aucun avantage.

Les inventeurs ont dû, pour surmonter le problème, s'écarter complètement des solutions de l'art antérieur en ce qui concerne la constitution des sous-ensembles. Dans la file d'attente suivant l'invention, telle que définie ci-dessus, la chaîne logique de commande est prévue pour engendrer uniquement, lors de l'opération d'écriture, des signaux logiques d'état qui suivent la progression de l'information à travers les registres de données jusqu'à ce que cette information atteigne le dernier registre vide précédant un registre occupé.

Dans un mode avantageux de réalisation, chaque commutateur est constitué par un multiplexeur 2, vers 1. La sortie du multiplexeur commande directement l'état du registre associé.

En général, chaque multiplexeur aura une entrée reliée à la sortie du multiplexeur de l'étage précédent une entrée reliée à la sortie de l'étage suivant et une entrée de commande reliée à sa propre sortie, le registre associé étant transparent lorsqu'il reçoit un zéro logique de sortie du multiplexeur, laquelle reflète l'état de l'entrée reliée au multiplexeur précédent lorsque l'entrée de commande reçoit un zéro et reflète l'état de l'entrée reliée au multiplexeur suivant lorsque l'entrée de commande reçoit un 1.

Pour qu'il y ait fonctionnement correct de la chaîne de multiplexeurs, il sera en général nécessaire de retarder la remontée de l'information de chaque multiplexeur au précédent. Pour cela, il suffit d'appliquer la sortie de chaque multiplexeur au précédent par l'intermédiaire d'un élément de retard. Cet élément de retard sera tel que la somme du retard qu'il fournit et du temps de traversée du multiplexeur soit supérieure au temps de commutation du multiplexeur.

La file d'attente peut être complétée par des sorties d'indication d'état prélevées à la sortie des commutateurs de certains au moins des étages. Sur chacune de ces sorties pourra être interposée une cellule logique de filtrage destinée à éliminer les transitoires provoqués par la descente ou la remontée de l'information.

L'invention sera mieux comprise à la lecture de la description qui suit d'un mode particulier de réalisation donné à titre d'exemple non limitatif. La description se réfère aux dessins qui l'accompagnent, dans lesquels:

La fig. 1, déjà mentionnée, est un schéma synoptique de principe montrant une file d'attente suivant l'art antérieur;

la fig. 2 est un schéma synoptique de principe montrant la coopération entre trois sous-ensembles successifs d'une file d'attente suivant l'invention;

la fig. 3 est un schéma synoptique montrant la constitution d'ensemble d'une file d'attente comportant des sous-ensembles du type montré en fig. 2;

la fig. 4 est un chronogramme montrant l'allure des signaux qui apparaissent à divers emplacements du synoptique de la fig. 3;

la fig. 5 est un schéma de principe montrant d'opération de filtrage de sortie destinée à assurer une plus grande sécurité de fonctionnement;

la fig. 6 est un schéma de principe d'une cellule de filtrage utilisable dans le schéma de la fig. 5;

la fig. 7 est un chronogramme montrant les signaux intervenant dans l'opération de filtrage.

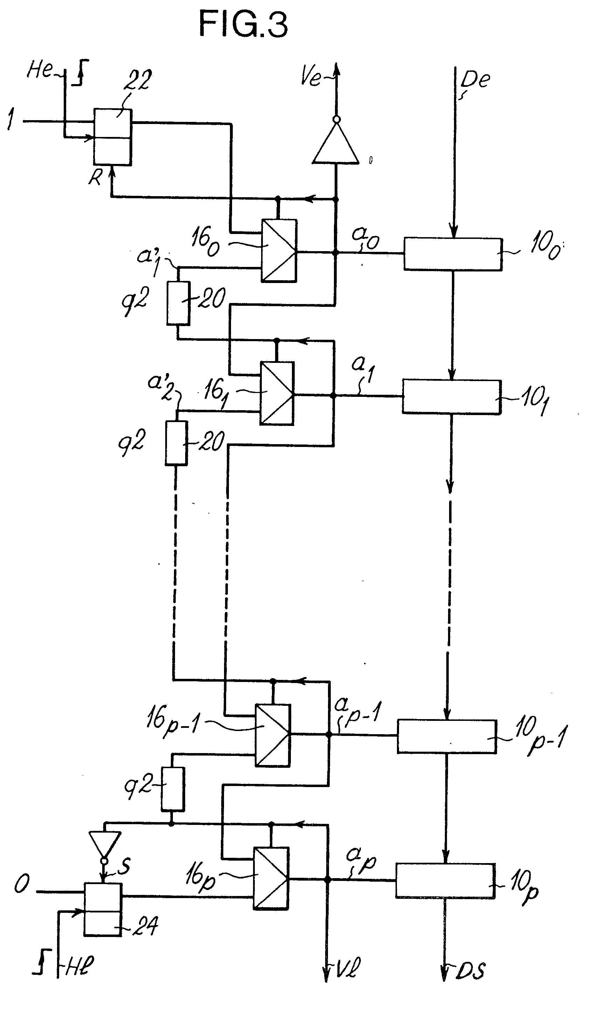

La constitution générale d'une file l'attente suivant l'invention apparaît sur la fig. 2, qui montre schématiquement le mode de commande par multiplexeur sur trois registres successifs, et sur la fig. 3, sur laquelle apparaissent les sous-ensembles de commande des premiers et derniers registres, dont la structure est particulière.

On voit sur la fig. 2 le commutateur $16_i$ associé au registre $10_i$, constitué par un multiplexeur 2 vers-1. La sortie $a_i$ du multiplexeur commande directement l'état du registre associé: si $a_i = 0$, le registre est transparent, si $a = 1$, le registre est verrouillé. L'évolution du commutateur $16_i$ est gouvernée par trois sources d'information, son état présent, l'état de l'étage au-dessus $16_{i-1}$, l'état de l'étage au-dessous $16_{i+1}$. Mais, à un instant donné, deux seulement de ces sources sont déterminantes.

En effet, si l'étage i est libre, l'action du commutateur $16_i$ n'est déterminée que par l'état de l'étage $i_{i-1}$.

De même s'il retient une information, son changement d'état ne peut provenir que de la disponibilité de l'étage du dessous d'ordre i+1.

Dans le cas de l'emploi d'un commutateur constitué par un multiplexeur, ces fonctions peuvent être obtenues en reliant l'entrée de commande 18 du multiplexeur à sa sortie. Si la sortie est à zéro, c'est la sortie du multiplexeur du dessus $16_{i-1}$ qui est déterminante. Si la sortie est à 1, c'est la sortie de l'étage $16_{i+1}$ qui est déterminante.

Dans la pratique, il sera nécessaire d'introduire un retard dans la commande d'un multiplexeur $16_i$ par le multiplexeur $16_{i+1}$, pour un motif qui sera exposé plus loin. Ce retard peut être obtenu à l'aide d'une ligne à retard $20_i$ grâce auquel un changement l'état de la sortie $a_{i+1}$ n'est analysé sous forme d'un ordre $a'_{i+1}$ par le multiplexeur $16_i$ qu'au bout d'un temps $q_2$.

On retrouve, sur la fig. 3, les entrées et sorties usuelles He, H1, DE, DS, Ve et V1 déjà montrées sur la fig. 1. La demande d'écriture est matérialisée par un front montant sur l'entrée He, reliée à une bascule 22 de prise en compte des demandes externes d'écriture. Le mot à écrire, placé à l'entrée DE de la file lorsque le front montant est appliqué, passe alors à travers tous les registres dans l'état transparent pour venir se stocker dans le dernier.

De même, les demandes de lecture sont matérialisées par des fronts montants appliqués sur l'entré H1 et, lorsque la file n'est pas vide, la première donnée accessible est disponible sur la sortie DS. L'activation de l'entrée H1 détruit au surplus cette information, qui est remplacée par le contenu du registre immédiatement supérieur $10_{p-1}$ s'il n'était pas vide.

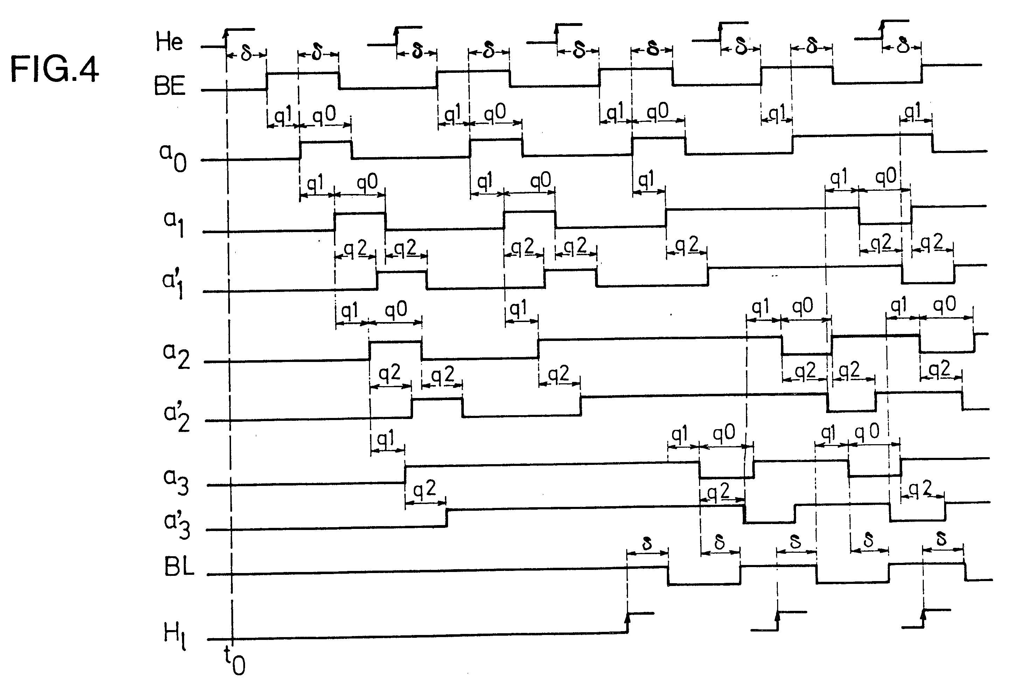

Le fonctionnement réel des circuits apparaît sur le chronogramme de la fig. 4, qui montre les cycles d'écriture et de lecture. Sur cette figure, chacune des lignes montre l'allure des signaux qui apparaissent au point du schéma synoptique de la fig. 3 qui est désigné par la même référence. Pour simplifier, on supposera que la file est à quatre étages, c'est-à-dire comporte quatre registres $10_0$, $10_1$, $10_2$ et $10_3$.

Dans ce fonctionnement apparaissent trois constantes de temps importantes:

$q_0$: temps de commutation de chaque multiplexeur 16, c'est-à-dire temps au bout duquel un ordre de commande se reflète en sortie;

$q_1$: temps de traversée du multiplexeur, c'est-à-dire temps au bout duquel l'état de l'entrée analysée se reflète à la sortie;

$q_2$: temps de parcours d'une ligne à retard 20.

Au surplus intervient, en entrée et en sortie, le temps $\delta$ de réaction des bascules d'écriture 22 et de lecture 24.

On supposera que l'information progresse au travers des registres 10, lorsqu'ils sont transparents, plus vite qu'au travers de la chaîne logique de commande. Mais si le cas contraire se présentait, il suffirait de provoquer un allongement du temps $q_1$ de traversée des multiplexeurs ou de prépositionner les données DE par rapport à la génération du signal He avec une avance suffisante pour garantir que l'information est arrivée au fond de la file lorsque celle-ci est vide, avant que le signal de commande fourni par le dernier multiplexeur $16_p$ ne verrouille le dernier registre $10_p$.

Dans le cas illustré sur la fig. 4, on ordre d'écriture est matérialisé à l'instant $t_0$ par un front montant sur l'entrée He. Ce front montant provoque, au bout du temps $\delta$, la montée de la bascule d'écriture 22 (ligne BE). Si l'on suppose le registre $10_0$ vide, donc transparent, la sortie $a_0$ est initialement à 0. Au bout du temps $q_1$ de traversée du multiplexeur $16_0$, la sortie $a_0$ passe à 1 et fait commuter de nouveau le multiplexeur $16_0$, au bout du temps $q_0$ de commutation. En effet, le signal $a_1$, et donc le signal $a'_1$, est à zéro si le registre $10_1$ est vide.

L'information descend ainsi jusqu'au dernier registre qui précède un registre plein et verrouillé.

L'utilité des retards $q_2$ dans les circuits de remontée de commande de chaque multiplexeur vers le multiplexeur précédent apparaît sur la fig. 4. Si l'on suppose que les signaux de sortie $a_i$ et $a_{i+1}$ de deux multiplexeurs consécutifs $16_i$ et $16_{i+1}$ (fig. 2) sont au niveau bas, le signal $a_i$ passe à l'état haut à la suite d'une écriture dans le registre $10_i$. Le multiplexeur $16_i$ regarde $a'_{i+1}$ au bout du temps de commutation $q_0$ (fig. 4). Il faut qu'à ce moment $a'_{i+1}$ reflète l'état de $a_{i+1}$ avant que ce dernier n'ait lui-même subi la commutation. Pour qu'il y ait un fonctionnement correct, il faut que les différents temps de propagation soient reliés par la relation:

$$q_0 < q_1 + q_2$$

Au surplus, la fig. 4 montre que le temps de descente de l'information par étage est égal à $q_1$, alors que le temps de remontée d'une information de «trou», c'est-à-dire de l'existence en aval d'un registre vide d'information, est de $q_1+q_2$.

La file d'attente dont la constitution de principe est montrée en fig. 3 doit être munie d'indicateurs d'état si l'on veut disposer d'une information concernant le contenu de la file.

Les états non plein ou non vide de la file sont indiqués, comme dans une file en registre de constitution classique, par des signaux Ve et Vl respectivement prélevés à la sortie du premier multiplexeur et à la sortie du dernier multiplexeur. $Ve = 0$ signifie que le premier registre $10_0$ est verrouillé et qu'aucune écriture ne peut donc être engagée.

Inversement, $Vl = 1$ indique qu'une information est disponible dans le dernier registre $10_p$.

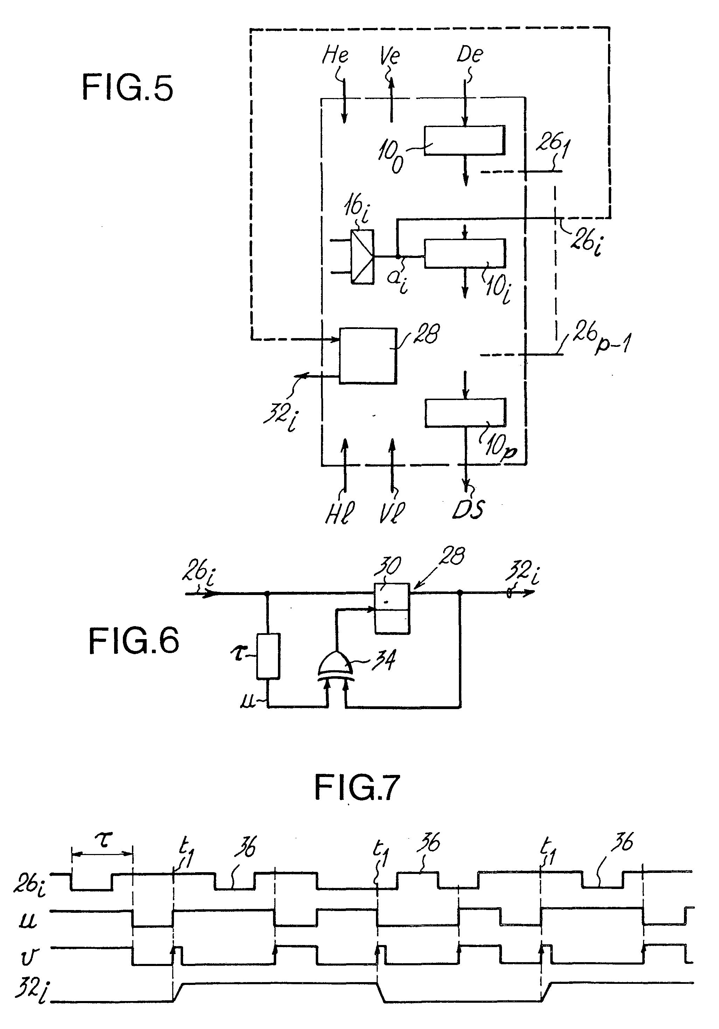

La file d'attente peut avantageusement être complétée par des éléments indiquant les états de remplissage intermédiaires. De tels éléments sont indiqués schématiquement sur la fig. 5.

Sur cette figure, seuls ont été représentés les registres $10_0$, $10_i$ et $10_p$, ainsi que les entrées et sorties. En principe, il suffit, pour déterminer que la file est au moins remplie jusqu'au niveau du registre i, de vérifier que le signal $a_i$ correspondant est au niveau 1. L'information peut alors être prélevée sur des sorties intermédiaires $26_1 \ldots 26_i$, $26_{p-1}$. Mais cette indication n'est pas certaine par suite des transitoires provoqués par la progression des informations et des trous. Ce défaut peut être écarté en interposant, sur chacune des sorties 26, une cellule logique de filtrage 28 destinée à faire disparaître les impulsions positives ou négatives ayant une durée inférieure à une valeur déterminée. La cellule de filtrage 28 peut avoir la constitution montrée en fig. 6 et comporter une bascule 30 interposée sur le trajet du signal vers la sortie $32_i$. L'entrée d'horloge de la bascule 30 reçoit un ordre élaboré par une porte OU EXCLUSIF 34 dont les entrées sont reliées l'une à la sortie $32_i$, l'autre à l'entrée par l'intermédiaire d'une ligne à retard $\tau$. Dès que la porte 34 détecte une différence entre le signal d'entrée retardé de $\tau$ et le signal de sortie, elle active l'entrée d'horloge de la bascule 30 qui saisit l'état actuel de $26_i$: on voit sur le chronogramme de la fig. 6, où les lignes indiquent la forme des signaux aux emplacements désignés par la même lettre sur la fig. 6, que toute impulsion d'une durée inférieure à $\tau$, par exemple celles désignées par 36, ne provoque aucun changement d'état de la bascule 30, les basculements n'étant provoqués que par des signaux représentatifs d'un véritable changement de remplissage de la file, comme indiqué aux instants $t_1$.

## Revendications

1. File d'attente asynchrone comprenant un empilement en cascade de p registres (10) identiques de stockage de données et une chaîne logique de commande de p sous-ensembles (16, 20) identiques associés chacun à un des registres, le premier registre de l'empilement étant muni de l'entrée unique de données de ladite file, caractérisée en ce que les registres (10) sont du type à verrouillage ayant un état transparent et un état verrouillé et en ce que chaque sous-ensemble comporte un commutateur (16) recevant sur ses entrées de signal, des signaux logiques représentatifs de l'état des sous-ensembles amont et aval pour transmettre sur sa sortie (a) l'un desdits signaux logiques d'entrée, la sortie (a) étant reliée au registre associé pour lui fournir un signal représentatif de l'état dudit sous-ensemble, la position du commutateur étant commandée par le niveau logique du signal de sortie dudit commutateur.

2. File d'attente selon la revendication 1, caractérisée en ce que chaque commutateur est constitué par un multiplexeur 2 vers 1 dont la sortie commande directement l'état du registre associé.

3. File d'attente selon la revendication 2, caractérisée en ce que chaque multiplexeur ($16_i$) comporte une entrée reliée à la sortie du multiplexeur de l'étage précédent ($16_{i-1}$), une entrée reliée à la sortie de l'étage suivant ($16_{i+1}$) et une entrée de commande reliée à sa propre sortie, le registre associé étant transparent lorsqu'il reçoit un zéro logique de la sortie du multiplexeur, laquelle reflète l'état de l'entrée reliée au multiplexeur précédent lorsque l'entrée de commande reçoit un zéro et reflète l'état de l'entrée reliée au multiplexeur suivant lorsque l'entrée de commande reçoit un 1.

4. File d'attente selon l'une quelconque des revendications 2 et 3, caractérisée en ce que la sortie de chaque multiplexeur ($16_i$) est appliquée directement à son entrée (18) et est appliquée par l'intermédiaire d'un élément de retard ($20_i$) à une entrée de données du multiplexeur précédent ($16_{i-1}$).

5. File d'attente selon la revendication 4, caractérisée en ce que l'élément de retard fournit un retard ($q_2$) tel que la somme de ce retard et du temps de traversée ($q_1$) du multiplexeur soit supérieur au temps de commutation ($q_0$) du multiplexeur.

6. File d'attente selon l'une quelconque des revendications précédentes, caractérisée en ce qu'elle comporte des sorties d'indication l'état prélevées à la sortie des commutateurs de certains au moins des étages.

7. File d'attente selon la revendication 6, caractérisée en ce qu'au moins une des sorties d'indication d'état est munie d'une cellule logique de filtrage (28) destinée à éliminer les transitoires de durée inférieure à un seuil ($\tau$) prédéterminé.

## Patentansprüche

1. Asynchroner Puffer mit einem Stapel von p in Kaskade geschalteten, identischen Datenspeicherregistern (10) und einer logischen Steuerkette aus p identischen Unterbaugruppen (16, 20), die jeweils mit einem der Register verbunden sind, wobei das erste Register des Stapels mit dem einzigen Dateneingang des Puffers versehen ist, dadurch gekennzeichnet, dass die Register (10) vom Verriegelungstyp sind, der einen durchgängigen Zustand und einen verriegelten Zustand hat, und dass jede Unterbaugruppe ein Schaltglied (16) aufweist, das an seinem Signaleingang logische Signale empfängt, die den Zustand der vorgeschalteten und nachgeschalteten Unterbaugruppe wiedergeben, um an seinem Ausgang (a) eines dieser logischen Eingangssignale zu übertragen, wobei der Ausgang (a) mit dem zugehörigen Register verbunden ist, um diesem ein Signal zu liefern, das den Zustand der genannten Unterbaugruppe wiedergibt, und die Stellung des Schaltgliedes durch den logischen Pegel des Ausgangssignals dieses Schaltgliedes gesteuert wird.

2. Puffer nach Anspruch 1, dadurch gekennzeichnet, dass jedes Schaltglied aus einem 2:1 Multiplexer besteht, dessen Ausgang direkt den Zustand des zugehörigen Registers steuert.

3. Puffer nach Anspruch 2, dadurch gekennzeichnet, dass jeder Multiplexer ($16_i$) einen Eingang, der mit dem Ausgang des Multiplexers der vorhergehenden Stufe ($16_{i-1}$) verbunden ist, einen Eingang, der mit dem Ausgang der nachfolgenden Stufe ($16_{i+1}$) verbunden ist und einen Steuereingang aufweist, der mit seinem eigenen Ausgang verbunden ist, wobei das zugehörige Register durchgängig ist, wenn es den logischen Wert «0» am Ausgang des Multiplexers empfängt, der einen Zustand des Eingangs wiedergibt, der den Zustand des Eingangs, der mit dem vorhergehenden Multiplexer verbunden ist, wiedergibt, wenn der Steuereingang den Wert Null empfängt, und den Zustand des Eingangs, der mit dem nachfolgenden Multiplexer verbunden ist, wiedergibt, wenn der Steuereingang den Wert «1» empfängt.

4. Puffer nach einem der Ansprüche 2 und 3, dadurch gekennzeichnet, dass das Ausgangssignal jedes Multiplexers ($16_i$) direkt an seinem Eingang (18) und über ein Verzögerungselement ($20_i$) an einem Dateneingang des vorhergehenden Multiplexers ($16_{i-1}$) liegt.

5. Puffer nach Anspruch 4, dadurch gekennzeichnet, dass das Verzögerungselement eine derartige Verzögerung ($q_2$) liefert, dass die Summe aus dieser Verzögerung und der Durchgangszeit ($q_1$) des Multiplexers grösser als die Schaltzeit ($q_0$) des Multiplexers ist.

6. Puffer nach einem der vorhergehenden Ansprüche, dadurch gekennzeichnet, dass er Ausgänge zum Anzeigen des Zustandes aufweist, die auf den Ausgang der Schaltglieder wenigstens einiger Stufen zugreifen.

7. Puffer nach Anspruch 6, dadurch gekennzeichnet, dass wenistens einer der Ausgänge zum Anzeigen des Zustandes mit einer logischen Filterstufe (28) versehen ist, die dazu bestimmt ist, Übergänge mit einer Dauer unter einem bestimmten Schwellenwert ($\tau$) auszuschalten.

**Claims**

1. Asynchronous FIFO having a cascade stack of p identical registers (10) for storage of data and a logic control channel having p identical subassemblies (16, 20) each associated with a respective one of the registers, the first register of the stack being provided with the single data input of said FIFO, characterized in that the registers (10) are latch registers having a transparent condition and a latched condition and in that each subassembly comprises a switch (16) which receives, on signal inputs thereof, logic signals representing the conditions of the upstream and downstream subassemblies for transmitting, on its output (a), one of said logic input signals, the output (a) being connected to the respective register for delivering thereto a signal representing the condition of said subassembly, the condition of the switch being controlled by the logic level of the output signal of said switch.

2. FIFO according to claim 1, characterized in that each switch consists of a 2-to-1 multiplexer whose output directly controls the condition of the associated register.

3. FIFO according to claim 2, characterized in that each multiplexer ($16_i$) comprises an input connected to the output of the multiplexer of the preceding section ($16_{i-1}$), an input connected to the output of the multiplexer of the following section ($16_{i+1}$) and a control input connected to its own output, the associated register being transparent when receiving a logic zero from the output of said multiplexer which output is a copy of the condition of the input connected to the preceding multiplexer when the control output receives a zero and is a copy of the condition of the input connected to the following multiplexer when the control input receives a one.

4. FIFO according to any one of claims 2 and 3, characterized in that the output of each multiplexer ($16_i$) is directly applied to its input (18) and is applied through a delay element ($20_i$) to a data input of the preceding multiplexer ($16_{i-1}$).

5. FIFO according to claim 4, characterized in that the delay element provides a time delay ($q_2$) which is such that the sum of that time delay and of the time duration necessary for passage through the multiplexer be higher than the switching time ($q_2$) of the multiplexer.

6. FIFO according to any one of the preceding claims, characterized in that it comprises condition indicating outputs connected to the outputs of the switches in certain at least of the sections.

7. FIFO according to claim 6, characterized in that at least one of the condition indicating outputs is provided with a logic filtering cell (28) for eliminating those transients which have a duration lower than a predetermined threshold ($\tau$).

# FIG.1

# FIG.2

# FIG.3

FIG.4

**FIG.5**

**FIG.6**

**FIG.7**